# EUROPÄISCHE PATENTSCHRIFT

(11) **EP 1 287 548 B1**
(45) Veröffentlichungstag und Bekanntmachung des Hinweises auf die Patenterteilung: **09.02.2011**
(21) Anmeldenummer: 01944923.0
(22) Anmeldetag: 10.05.2001
(51) Int. Cl.: H01J 37/32

(54) **PLASMAÄTZANLAGE**
PLASMA ETCHING EQUIPMENT
INSTALLATION DE GRAVURE AU PLASMA

(30) Priorität: 19.05.2000 DE 10024883
(43) Veröffentlichungstag der Anmeldung: 05.03.2003
(73) Patentinhaber: ROBERT BOSCH GMBH, 70442 Stuttgart (DE)
(72) Erfinder: LAERMER, Franz, 71263 Weil der Stadt (DE); SCHILP, Andrea, 73525 Schwaebisch Gmuend (DE)
(86) Internationale Anmeldenummer: PCT/DE2001/001778
(87) Internationale Veröffentlichungsnummer: WO 2001/088962

(56) Entgegenhaltungen:
- WO-A-99/40609
- US-A- 5 336 366
- US-A- 5 753 886

## Beschreibung

Die Erfindung betrifft eine Plasmaätzanlage zum insbesondere anisotropen Ätzen eines Substrates durch Einwirken eines Plasmas nach der Gattung des Hauptanspruchs.

### Stand der Technik

Aus DE 42 41 045 C1 ist ein Siliziumhochratenätzprozess bekannt, bei dem Silizium mittels induktiver Plasmaanregung geätzt wird. Dabei ist es zum Erreichen möglichst hoher Ätzraten erforderlich, in dem erzeugten Plasma eine möglichst hohe Fluorradikalenkonzentration bereitzustellen. Dies geschieht üblicherweise durch Einstrahlung entsprechend hoher Hochfrequenzleistungen in die induktive Plasmaquelle mit typischen Leistungswerten von 3 bis 6 kW unter gleichzeitig erhöhtem Prozessdruck von 30 bis 100 µbar beziehungsweise, wenn die erforderliche Uniformität des erzeugten Plasmas dies zulässt, bis zu 250 µwar. Bei derartigen Prozessen treten jedoch neben einer gewünschten Steigerung der Fluorradikalendichte auch unerwünscht große Dichten an Ionen auf, die den eigentlichen Ätzprozess stören, und die für eine ausreichend hohe Maskenselektivität schädlich sind. Gleichzeitig heizen diese Ionen den zu ätzenden Wafer auch unerwünscht auf und führen zu Profilabweichungen. Im Allgemeinen muss daher durch eine geeignete Vorrichtung in der Plasmaätzanlage nachträglich wieder dafür gesorgt werden, dass die Dichte der erzeugten Ionen auf zulässig niedrige Werte reduziert und vor allem homogenisiert wird. Dazu ist bereits vorgeschlagen worden, eine Rekombination von Ionen und Elektronen mittels sogenannter Diffusionsstrecken oder an Aperturkonstruktionen, beispielsweise nach Art der DE 197 34 278 A1, zu ermöglichen. Dabei geht der Anteil der in das Plasma eingekoppelten Hochfrequenzleistung, der zur Erzeugung unerwünscht hoher Ionendichte verwendet wurde, in Form von Wärme oder Strahlung verloren.

Obwohl die bekannten Vorrichtungen zur Reduzierung der Ionendichte vielfach sehr erfolgreich sind, treten in der Praxis, insbesondere im Randbereich des zu ätzenden Substrates, immer noch Profilabweichungen, Profilasymmetrien, Ätzratenüberhöhungen oder regelmäßige oder unregelmäßige Profilhinterschneidungen auf, die auch unter dem Begriff "Beaking"-Effekt bekannt sind, und die für viele Applikationen nicht tolerierbar sind.

Problematisch bei den bekannten Vorrichtungen zur Reduzierung der Ionendichte ist insbesondere, dass eine um ein bis zwei Größenordnungen überhöhte Ionendichte auf das gewünschte Maß über der gesamten Oberfläche des zu ätzenden Substrates von beispielsweise 150 oder 200 mm Durchmesser völlig homogen vorgenommen werden muss, ohne dabei Verzerrungen des Plasmapotentials an der Oberfläche des zu ätzenden Substrates zu bewirken. Durch derartige Verzerrungen des Plasmapotentials lokal überhöhte Ionendichten und/oder lokal überhöhte Ionenenergien führen dort dann zu den vorstehend erläuterten schädlichen Effekten.

In dem Patent DE 199 00 179 C1 wurde weiter bereits eine Plasmaätzanlage zum Hochratenätzen von Silizium mittels induktiver Plasmaanregung vorgeschlagen, bei der die Plasmaquelle mit einer balancierten Speisung der induktiven Erregerspule versehen ist. Eine derartige Plasmaätzanlage mit einem symmetrisch aufgebauten Anpassnetzwerk zur Anpassung der Impedanz der eingekoppelten Hochfrequenzleistung an die Impedanz des erzeugten Plasmas und die gleichzeitig balancierte Speisung der induktiven Erregerspule führt zu einer minimalen Einkopplung unerwünschter Verschiebeströme in das erzeugte Plasma und damit zu minimalen Verzerrungen des Plasmas. Eine derartige symmetrische Spulenspeisung ist vor allem bei hohen Leistungswerten von mehr als 3 kW vorteilhaft.

Aus der WO99/4060 A ist eine gattungsbildende Plasmaätzanlage bekannt mit zwei separaten Plamaerzeugungsvorrichtungen bekannt.

Aus der US 5,336,366 ist ein Trockenätzverfahren mit zwei Plasmakammern mit einer Druckdifferenz bekannt.

### Vorteile der Erfindung

Die erfindungsgemäße Plasmaätzanlage hat gegenüber dem Stand der Technik den Vorteil, dass im oberen Teil der Reaktorkammer, die als zweite Plasmaerzeugungsvorrichtung dient, im Falle eines Prozesses nach Art der DE 42 41 045 C1 ein hochdichtes Plasma mit einer hohen Dichte von Ätz- und Passivierspezies generiert werden kann, wobei übermäßig hohe Ionendichten und unerwünschte Plasmapotentialstörungen und Inhomogenitäten in dem zunächst erzeugten zweiten Plasma dadurch beseitigt werden, dass diese Ionen beim Durchtritt durch die erste Gaszuführung, die insbesondere gleichzeitig als Entladevorrichtung dient, zumindest weitgehend mit Elektronen rekombinieren, so dass die Ionendichte des zugeführten Reaktivgases in die nachgeschaltete erste Plasmaerzeugungsvorrichtung praktisch null bzw. vernachlässsigbar ist. Gleichzeitig werden somit auch Dichteinhomogenitäten und Potentialinhomogenitäten ausgelöscht.

Weiterhin ist vorteilhaft, dass mit der erfindungsgemäßen Plasmaätzanlage die für den eigentlichen Ätzprozess tatsächlich benötigte Ionendichte dann in einer ersten Plasmaerzeu gungsvorrichtung, in der sich auch das zu ätzende Substrat befindet, wieder definiert neu generiert wird.

Diese erste Plasmaerzeugungsvorrichtung wird dazu bevorzugt mit einer deutlich kleineren Leistung betrieben als die zweite Plasmaerzeugungsvorrichtung, so dass dank dieser niedrigeren Leistung die Ionengeneration in dieser ersten Plasmaerzeugungsvorrichtung homogen und frei von Störungen oder Plasmapotentialverwerfungen erfolgt. Insgesamt wird somit durch die erfindungsgemäße Plasmaätzanlage erreicht, dass zunächst die in der zweiten Plasmaerzeugungsvorrichtung auftretende Ionendichte zunächst auf null gesetzt wird, und dass diese dann, mittels der ersten Plasmaerzeugungsvorrichtung und ausgehend von null, homogen und aktiv wieder auf den gewünschten Wert für den eigentlichen Ätzprozess aufgebaut wird.

Darüber hinaus ist vorteilhaft, dass die erfindungsgemäße Plasmaätzanlage ohne großen Aufwand durch Umbau bzw. Ergänzung vorhandener, insbesondere induktiv gekoppelter Plasmaätzanlagen realisierbar ist, ohne dass hohe Investitionskosten anfallen.

Erfindungsgemäß ist es besonders vorteilhaft, wenn sowohl die erste Plasmaerzeugungsvorrichtung als auch die zweite Plasmaerzeugungsvorrichtung eine induktiv gekoppelte Plasmaerzeugungsvorrichtung ist, die jeweils mit einer ICP-Spule als Plasmaquelle versehen sind.

Vorteilhafte Weiterbildungen der Erfindung ergeben sich aus den in den Unteransprüchen genannten Maßnahmen.

Weiter ist vorteilhaft, wenn die erste Plasmaerzeugungsvorrichtung und die zweite Plasmaerzeugungsvorrichtung über eine gasdurchlässige, insbesondere geerdete Entladungsvorrichtung miteinander verbunden sind, die einerseits die Entladung von aus dem zweiten Plasma stammenden Ionen und/oder Elektroden bewirkt, und die andererseits gleichzeitig als erste Gaszufuhr zu der ersten Plasmaerzeugungsvorrichtung dient. Dazu ist diese Entladevorrichtung beziehungsweise Gaszufuhr bevorzugt als Ionenfilter in Form einer metallischen Lochplatte, eines dünngewebten metallischen Netzes, einer metallischen oder keramischen Lochplatte, eines Gaszuführungsringes, der die erste Plasmaerzeugungsvorrichtung mit der zweiten Plasmaerzeugungsvorrichtung verbindet, oder einer sogenannten "Showerhead"-Konstruktion, d.h. in Form eines "Duschkopfes" ausgeführt, die innerhalb des Reaktorkessels bevorzugt auf etwa halber Höhe platziert ist, und diesen somit in zwei, etwa gleich große Räume teilt, die der ersten Plasmaerzeugungsvorrichtung beziehungsweise der zweiten Plasmaerzeugungsvorrichtung zugeordnet sind. Im Übrigen kann die Entladevorrichtung neben einem Metall oder einer Keramik auch aus einem anderen dielektrischen Material ausgeführt sein.

Besonders vorteilhaft ist in diesem Zusammenhang, wenn die Entladevorrichtung als metallisches Netz ausgeführt ist, das die wirksame Gasdurchtrittsfläche für ein Gas aus der zweiten Plasmaerzeugungsvorrichtung in die erste Plasmaerzeugungsvorrichtung auf 0,01% bis 80% der ohne die Entladungsvorrichtung in der Reaktorkammer vorliegenden Durchtrittsfläche zwischen den Plasmaerzeugungsvorrichtungen reduziert.

Weiter kann die Entladevorrichtung bzw. die erste Gaszuführung vorteilhaft auch dazu genutzt werden, in der zweiten, der ersten Plasmaerzeugungsvorrichtung vorgeschalteten Plasmaerzeugungsvorrichtung einen höheren Prozessdruck einzustellen als in der nachfolgenden ersten Plasmaerzeugungsvorrichtung. Diese Prozessdruckdifferenz ist dabei in einfacher Weise über die wirksame Gasdurchtrittsfläche der Entladevorrichtung bzw. der ersten Gaszuführung und damit deren Strömungswiderstand einstellbar. Durch den höheren Prozessdruck in der zweiten Plasmaerzeugungsvorrichtung werden dort zunächst mehr Radikale aus dem dort zugeführten zweiten Reaktivgas erzeugt, als dies bei einem niedrigeren Druck der Fall ist, da es über den Parameter Prozessdruck zu einer Verschiebung des Gleichgewichtes in der Bildung von Radikalen und Ionen aus dem Reaktivgas zu Gunsten der Radikalenbildung kommt.

Mit dieser Druckerhöhung ist weiter in der zweiten Plasmaerzeugungsvorrichtung zwar unvermeidlich eine erheblich inhomogenere Ionenverteilung in dem erzeugten zweiten Plasma verbunden, dies ist jedoch nicht störend, da durch die nachfolgende Entladevorrichtung ohnehin zumindest nahezu alle Ionen ausgelöscht bzw. rekombiniert werden. Gleichzeitig herrscht nun in der nachgeschalteten ersten Plasmaerzeugungsvorrichtung ein relativ niedriger Prozessdruck, was den zusätzlichen Vorteil hat, dass dort Ionen mit besonders uniformer Ionenverteilung generiert werden, und die Wechselwirkung zwischen dem dort erzeugten ersten Plasma und dem zu ätzenden Substrat über der gesamten Oberfläche des Substrates zu besonders homogenen Ätzergebnissen führt.

Weiter führt der niedrigere Prozessdruck in der ersten Plasmaerzeugungsvorrichtung dort zwar zu einer gegenüber der Radikalenbildung verstärkten Ionenbildung, dies ist jedoch ebenfalls nicht nachteilig oder störend, da die gewünschten Radikale für den Ätzprozess in wesentlich größerem Ausmaß in der vorgeschalteten, mit erhöhtem Prozessdruck und erhöhter Leistung betriebenen zweiten Plasmaerzeugungsvorrichtung aus dem zweiten Reaktivgas generiert werden.

Insgesamt kann daher durch die mittels der Entladevorrichtung bzw. der ersten Gaszuführung definiert einstellbare

Prozessdruckdifferenz in jeder der beiden Plasmaerzeugungsvorrichtungen die Plasmaerzeugung jeweils unter optimalen Druckbedingungen hinsichtlich Ionen- und Radikalenbildung erfolgen. Zudem bleibt durch die Druckerniedrigung von der zweiten zu der ersten Plasmaerzeugungsvorrichtung die Massenstromdichte (p v) für die erzeugten Radikale, d.h. die für die erreichten Ätzraten maßgebliche Prozessgröße, unverändert.

Zusammenfassend wird durch die vorgesehene Entladevorrichtung zwischen dem ersten Plasmaerzeugungsbereich und dem zweiten Plasmaerzeugungsbereich zunächst eine zumindest weitgehende Rekombination von Ionen und Elektronen durch eine Plasmawandwechselwirkung beim Durchtritt des ionisierten und mit Radikalen durchsetzten, aus der zweiten Plasmaerzeugungsvorrichtung kommenden Reaktivgases bewerkstelligt. Das derart entladene Reaktivgas wird dann der ersten Plasmaerzeugungsvorrichtung als erstes Reaktivgas zugeführt, und dort erneut ionisiert. Somit wird erreicht, dass unmittelbar unter der Entladevorrichtung nur noch Radikale in dem ersten Reaktivgas enthalten sind und keine Ionen mehr, so dass auch Inhomogenitäten der ursprünglich erzeugten Ionendichteverteilung dort aufgehoben sind. Daneben ist damit aber auch eine definierte Druckdifferenz bzw. ein Druckgefälle zwischen den beiden Plasmaerzeugungsvorrichtungen einstellbar.

Weiter stellt die Entladevorrichtung, sofern sie aus Metall hergestellt ist, vorteilhaft auch eine Referenzerde für das erste Plasma in der ersten Plasmaerzeugungsvorrichtung dar, so dass damit ein definiertes Referenzpotential für die dort ablaufenden elektrischen Prozesse gegeben ist. Zudem sind in diesem Fall am Ort der Entladevorrichtung auch aus dem ursprünglich erzeugten zweiten Plasma herrührende Plasmapotentialinhomogenitäten ausgelöscht und ganzflächig durch ein definiertes Erdpotential ersetzt.

Ein weiterer Vorteil der metallischen Entladevorrichtung ist, dass damit die hochfrequenten Wechselfelder der zweiten ICP-Spule in der zweiten Plasmaerzeugungsvorrichtung von der ersten Plasmaerzeugungsvorrichtung abgeschirmt werden können, und diese somit nicht in den unteren Teil der Reaktorkammer vordringen. Damit ist sichergestellt, dass die an der zweiten ICP-Spule aufgrund der dort anliegenden hohen Leistungen bestehende Tendenz zur Ausbildung von Inhomogenitäten und Plasmastöreffekten nicht in den unteren Teil der Reaktorkammer, das heißt den ersten Plasmaerzeugungsbereich, durchgreifen kann, der somit möglichst frei von Störungen betrieben wird.

Die erste ICP-Spule in dem ersten Plasmaerzeugungsbereich hat somit insgesamt nur noch die Aufgabe, in diesem unteren Teil der Reaktorkammer die für den durchgeführten anisotropen Ätzprozess tatsächlich erforderliche Konzentration von Ionen wieder aufzubauen, wofür insbesondere unter einem für die Ionenerzeugung günstigen Prozessdruck eine geringe Leistung ausreicht. Auf diese Weise wird es mit der erfindungsgemäßen Plasmaätzanlage nunmehr sehr vorteilhaft möglich, in der zweiten Plasmaerzeugungsvorrichtung mit hohen Hochfrequenzleistungen von typischerweise 3 kW bis 6 kW und einem gegenüber der nachgeschalteten ersten Plasmaerzeugungsvorrichtung signifikant erhöhten Prozessdruck Reaktivgasspezies in Form von Radikalen zu erzeugen, die dann dem ersten Plasmaerzeugungsbereich zugeführt werden, wo mit Hilfe einer ersten ICP-Spule ein erstes Plasma unterhalten wird, das im Wesentlichen nur noch dazu dient, eine beispielsweise für den Ätzprozess nach Art der DE 42 41 045 C1 benötigte Ionendichte sicherzustellen, wozu Leistungen von 400 W bis 1000 W völlig ausreichen. Besonders vorteilhaft ist in diesem Zusammenhang, wenn die Druckdifferenz zwischen den beiden Plasmaerzeugungsvorrichtungen zwischen 10 µbar und 250 µbar, insbesondere 30 µbar bis 70 µbar, liegt.

Im Übrigen sei erwähnt, dass es zur Vermeidung von Ablagerungen auf der ersten Gaszuführung beziehungsweise Entladevorrichtung vorteilhaft ist, wenn diese beheizbar ist.

Zur Einkoppelung von Hochfrequenzleistung in die erste ICP-Spule beziehungsweise in die zweite ICP-Spule stehen zwei Möglichkeiten zur Wahl.

Einerseits kann vorgesehen sein, dass jede dieser beiden ICP-Spulen ein separates Hochfrequenzbauteil mit einem eigenen Hochfrequenzgenerator und einem zugehörigen Anpassnetzwerk zur Impedanzanpassung der jeweiligen Plasmaerzeugungsvorrichtung an die Impedanz des betreffenden Plasmas aufweist. In diesem Fall eignet sich für das zweite Plasma vor allem ein Hochfrequenzgenerator mit einem großen Leistungsbereich von beispielsweise 6 kW, während für das erste Plasma ein kleinerer Hochfrequenzgenerator mit einem Leistungsbereich von beispielsweise 1000 W ausreichend ist. Um Intensitätsschwebungen in den erzeugten Plasmen zu vermeiden, werden diese beiden Hochfrequenzgeneratoren dann weiter bevorzugt phasensynchronisiert bei einer gemeinsamen Frequenz, beispielsweise 13,56 MHz, betrieben, oder es werden alternativ zwei separate Hochfrequenzgeneratoren mit zwei unterschiedlichen Frequenzen von beispielsweise 13,56 MHz für die zweite ICP-Spule und 12,56 MHz, 2 MHz oder 380 kHz für die erste ICP-Spule eingesetzt.

Da der Betrieb zweier separater Hochfrequenzgeneratoren mit zwei zugeordneten Anpassnetzwerken an ein und derselben Plasmaätzanlage einen nicht unerheblichen Kostenfaktor darstellt, sieht die Erfindung vor, die erste Plasmaerzeugungsvorrichtung und die zweite Plasmaerzeugungsvorrichtung mit einem gemeinsamen Hochfrequenzbauteil mit einem gemeinsamen Hochfrequenzgenerator und einem gemeinsamen Anpassnetzwerk zu betreiben. Dabei nutzt man vorteilhaft die bereits aus DE 199 00 179 C1 bekannte Speisung einer ICP-Spule in einer Plasmaätzanlage mit Hilfe eines symmetrisch aufgebauten Anpassnetzwerkes und einer symmetrisch aufgebauten Spulenspeisung aus, die jedoch aufgrund der nunmehr vorhandenen zwei ICP-Spulen dahingehend modifiziert werden muss, dass an zwei symmetrisch zu einem Mittelabgriff der zweiten ICP-Spule angeordneten Abgriffen die erste ICP-Spule mit einem Teil der zweiten ICP-Spule parallel geschaltet wird.

Auf diese Weise wird vorteilhaft erreicht, dass die erste ICP-Spule im elektrischen Sinne als Shunt an der zweiten ICP-Spule wirkt, das heißt, sie trägt einen mehr oder weniger großen Anteil des gesamten Spulenstromes. Insbesondere ist es nunmehr durch definierte Wahl oder Verschiebung der Lage der beiden symmetrischen Abgriffe an der zweiten ICP-Spule in einfacher Weise möglich, den Anteil des Spulenstromes, der durch die erste ICP-Spule fließt, und damit die Aufteilung der Spulenströme und der damit einhergehenden, in das erste beziehungsweise zweite Plasma eingekoppelten Hochfrequenzleistungen, zu bestimmen.

Insgesamt wird, ausgehend von einer Plasmaätzanlage gemäß DE 199 00 179 C1, diese derart modifiziert, dass nunmehr zwei ICP-Spulen vorgesehen sind, von denen eine einem Teil der anderen parallel geschaltet ist, so dass die Anordnung der beiden Spulen als Serien-Parallel-Schaltung von Induktivitäten aufzufassen ist, die wiederum eine Gesamtinduktivität L bilden. Diese Verschaltung der ICP-Spulen ermöglicht dann weiter vorteilhaft auch eine Impedanzanpassung durch ein einziges Anpassnetzwerk, wobei die hohe einkoppelte Hochfrequenzleistung in die zweite ICP-Spule an das hochdichte zweite Plasma im oberen Teil der Reaktorkammer angepasst wird, und die untere, mit nur geringer Hochfrequenzleistung betriebene erste ICP-Spule lediglich mitläuft. Insbesondere ist diese erste ICP-Spule dabei dann ebenfalls hinsichtlich ihrer Impedanz gut an das Plasma angepasst, da sie als Teil einer LC-Gesamtanordnung insgesamt resonant abgestimmt ist.

Zusammenfassend hat die erste Plasmaerzeugungsvorrichtung auch in dieser Verschaltung der ICP-Spulen im Wesentlichen nur noch die Aufgabe, eine kontrollierte Ionisation des Reaktivgases aus der zweiten Plasmaerzeugungsvorrichtung bestehend aus neutralen Radikalen und noch unverbrauchten Prozessgasen beziehungsweise Reaktivgasen zu bewirken, wozu ein nur geringer Teil der insgesamt der zweiten ICP-Spule zugeführten Hochfrequenzleistung ausreichend ist. Da aufgrund der in der erläuterten Weise modifizierten, aus DE 199 00 179 C1 bekannten Spulenspeisung nunmehr auch die zweite ICP-Spule symmetrisch betrieben wird, erfolgt weiter dann auch die Ionisation des Reaktivgases in der ersten Plasmaerzeugungsvorrichtung besonders homogen und frei von Störungen, d.h. insbesondere frei von einer kapazitiven Einkopplung von Verschiebeströmen.

Im Übrigen sei noch betont, dass zur weiteren Homogenisierung der Plasmaintensität und zur weiteren Verringerung von Profilabweichungen beziehungsweise Ätzratenüberhöhungen in der ersten Plasmaerzeugungsvorrichtung zusätzlich eine sogenannte Apertur vorgesehen sein kann, wie sie beispielsweise aus DE 197 34 278 A1 bekannt ist. Darüber hinaus kann es für gewisse Anwendungen auch vorteilhaft sein, wenn die Plasmaerzeugung in der ersten Plasmaerzeugungsvorrichtung und/oder in der zweiten Plasmaerzeugungsvorrichtung zusätzlich mit Hilfe eines Magnetfeldes unterstützt wird.

### Zeichnungen

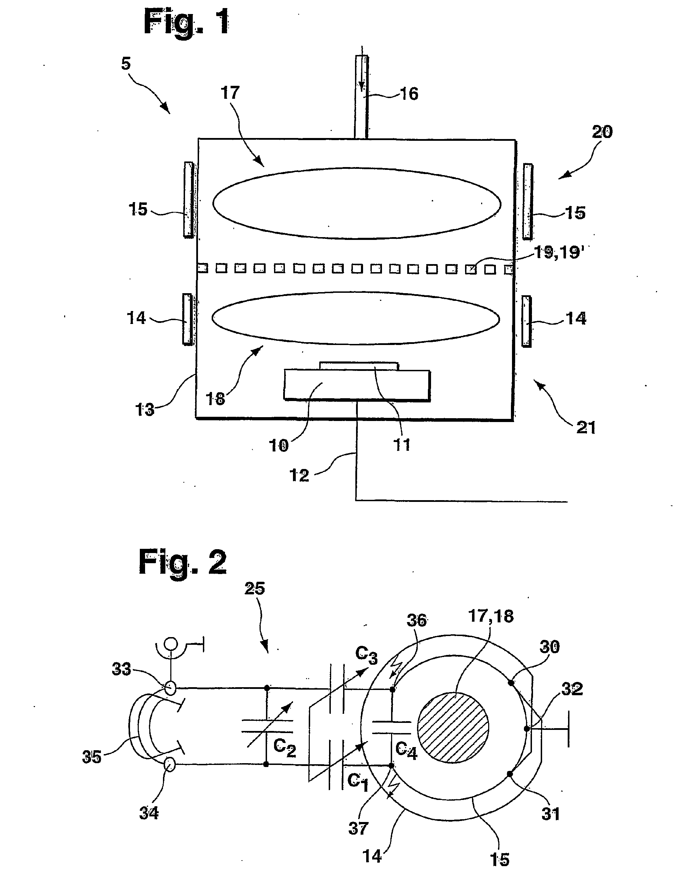

Die Erfindung wird anhand der Zeichnung und in der nachfolgenden Beschreibung näher erläutert. Die Figur 1 zeigt eine Prinzipskizze einer erfindungsgemäßen Plasmaätzanlage im Schnitt. Die Figur 2 zeigt ein gemeinsames Anpassnetzwerk zur Speisung der beiden ICP-Spulen 14, 15 in der Plasmaätzanlage gemäß Figur 1.

### Ausführungsbeispiele

Die Erfindung geht zunächst aus von einer Plasmaätzanlage, die prinzipiell aus DE 199 00 197 C1 bekannt ist, und die wie nachstehend erläutert modifiziert wird.

Mit dieser modifizierten Plasmaätzanlage wird dann weiter ein anisotroper Plasmaätzprozess für Silizium betrieben, wie er in DE 42 41 045 C1 ausführlich beschrieben ist.

Im einzelnen weist die Plasmaätzanlage 5 gemäß Figur 1 eine Reaktorkammer 13 auf, die mittels einer Entladevorrichtung 19' in etwa gleich große zwei Bereiche unterteilt ist, die einer ersten Plasmaerzeugungsvorrichtung 21 im unteren Teil der Reaktorkammer 13 und einer zweiten Plasmaerzeugungsvorrichtung 20 im oberen Teil der Reaktorkammer 13 zugeordnet sind. Die Reaktorkammer 13 weist weiter eine zweite Gaszuführung 16 zu einem zweiten Plasmaerzeugungsbereich 17 und eine erste Gaszuführung 19 zu einem ersten Plasmaerzeugungsbereich 18 auf.

Die erste Gaszuführung 19 ist dabei in Form eines metallischen Netzes ausgebildet, das die Gasdurchtrittsfläche zwischen der ersten Plasmaerzeugungsvorrichtung 21 und der zweiten Plasmaerzeugungsvorrichtung 20 auf ca. 0,01% bis 80% der Querschnittsfläche der Reaktorkammer 13 an dieser Stelle reduziert. Insbesondere dient die erste Gaszuführung 19 gleichzeitig auch als Entladevorrichtung 19' und als Strömungswiderstand zur Einstellung einer Druckdifferenz Δp zwischen der ersten und der zweiten Plasmaerzeugungsvorrichtung 20, 21. Diese Druckdifferenz beträgt im erläuterten Beispiel 10 bis 100 µbar, insbesondere 50 µbar.

Weiter ist gemäß Figur 1 vorgesehen, dass die erste Plasmaerzeugungsvorrichtung 21 und die zweite Plasmaerzeugungsvorrichtung 20 jeweils eine zugeordnete erste ICP-Spule 14 beziehungsweise eine zugeordnete zweite ICP-Spule 15 aufweisen. Insofern handelt es sich im Falle beider Plasmaerzeugungsvorrichtungen 20, 21 um induktiv gekoppelte Plasmaerzeugungsvorrichtungen, bei denen mit Hilfe der beiden ICP-Spulen 14, 15 jeweils ein hochfrequentes elektromagnetisches Wechselfeld generiert wird, das in dem ersten Plasmaerzeugungsbereich 18 beziehungsweise in dem zweiten Plasmaerzeugungsbereich 17 jeweils durch Einwirken auf reaktive Teilchen aus einem zugeführten Reaktivgas ein Plasma zündet beziehungsweise betreibt.

Darüber hinaus zeigt Figur 1, dass innerhalb der ersten Plasmaerzeugungsvorrichtung 21 eine Substratelektrode 10 mit einem darauf angeordneten zu ätzenden Substrat 11, beispielsweise einem Siliziumwafer, angeordnet ist. Die Substratelektrode 10 steht darüber hinaus über eine Zuleitung 12 mit einem nicht dargestellten, an sich bekannten Hochfrequenzgenerator in Verbindung, mit dem eine Substratelektrodenspannung in die Substratelektrode 10 einkoppelbar ist. Auf diese Weise wird gewährleistet, dass in dem ersten Plasmaerzeugungsbereich 18 vorliegende beziehungsweise erzeugte Ionen in Richtung auf das Substrat 11 hin beschleunigt werden.

Mit der Plasmaätzanlage 5 wird nun der bereits aus DE 42 41 045 C1 bekannte anisotrope Ätzprozess für Silizium durchgeführt, indem abwechselnd Ätzschritte und Passivierschritte ausgeführt werden, wobei während der Ätzschritte aus einem Fluor liefernden Gas, beispielsweise Schwefelhexafluorid, Fluorradikale, und während der Passivierschritte aus einem teflonartige Filme bildenden Gas, beispielsweise C₄F₈, polymerisationsfähige Radikale, beispielsweise (CF₂)ₙ, gebildet werden. Weiter wird dieser Prozess üblicherweise mit einem Sauerstoffzusatz von 10% bis 20% des Flusses an Schwefelhexafluorid in den Ätzschritten betrieben, um schädliche Schwefelausscheidungen im Abgasbereich der Plasmaätzanlage 5 zu unterdrücken.

Um eine möglichst hohe Ätzrate in Silizium und möglichst hohe Dichten an Fluorradikalen während der Ätzschritte als auch möglichst hohe Dichten von teflonartige Filme bildenden Radikalen während der Passivierschritte zu erzeugen, wird weiter über die zweite Plasmaerzeugungsvorrichtung 20 beziehungsweise die zweite ICP-Spule 15 eine möglichst hohe Plasmaleistung von 3 kW bis 7 kW unter erhöhten Prozessdruck von 30 µbar bis 250 µbar, vorzugsweise 40 µbar bis 100 µbar, in das dort erzeugte Plasma eingekoppelt.

Die erste ICP-Spule 14 beziehungsweise die erste Plasmaerzeugungsvorrichtung 21 wird dann mit einer wesentlich geringeren eingekoppelten Hochfrequenzleistung von beispielsweise 400 W bis 1000 W und einem um Δp niedrigeren Prozessdruck betrieben als die zweite ICP-Spule 15. Insbesondere beträgt der Prozessdruck in der ersten Plasmaerzeugungsvorrichtung 5 µbar bis 30 µbar, vorzugsweise 10 µbar.

Schließlich ist im Fall der Plasmaätzanlage 5 gemäß Figur 1 vorgesehen, dass sowohl die erste ICP-Spule 14 als auch die zweite ICP-Spule 15 über entsprechende Anschlussleitungen mit einem nicht dargestellten gemeinsamen Hochfrequenzbauteil mit einem gemeinsamen Hochfrequenzgenerator und einem gemeinsamen Anpassnetzwerk 25 verbunden sind. Dies wird mit Hilfe der Figur 2 näher erläutert.

Die Figur 2 zeigt eine Prinzipskizze eines gemeinsamen Anpassnetzwerkes 25, wobei zusätzlich die erste ICP-Spule 14 und die zweite ICP-Spule 15 gemäß Figur 1 in Draufsicht dargestellt ist. Insbesondere sei betont, dass die Reaktorkammer 13 gemäß Figur 1 zylindrisch ausgebildet ist, wobei die erste ICP-Spule 14 und die zweite ICP-Spule 15 diese Reaktorkammer 13 bereichsweise umgeben.

Im Einzelnen weist das gemeinsame Anpassnetzwerk 25 zunächst einen ersten Speisepunkt 33 auf, an dem über eine asymmetrische Koaxialleitung mit einer Impedanz von 50 Ω aus dem nicht dargestellten gemeinsamen Hochfrequenzgenerator in an sich bekannter Weise eine Hochfrequenzleistung von 3 kW bis 7 kW mit einer Frequenz von 13,56 MHz in das gemeinsame Anpassnetzwerk 25 einkoppelbar ist. Weiter ist vorgesehen, dass dieser erste Speisepunkt 33 über eine Verzögerungsleitung 35 mit einem zweiten Speisepunkt 34 verbunden ist. Durch die Verzögerungsleitung 35 wird in aus DE 199 00 179 C1 bekannter Weise eine Phasenverschiebung von λ/2 der am ersten Speisepunkt 33 eingekoppelten Hochfrequenzleistung gegenüber dem zweiten Speisepunkt 34 gewährleistet.

Insgesamt liegt somit an den beiden Speisepunkten 33, 34 jeweils eine hochfrequente Wechselspannung gleicher Frequenz und betragsmäßig zumindest nahezu gleicher Amplitude an, die gegeneinander um 180° phasenverschoben sind. Die Impedanz zwischen den Speisepunkten 33,34 beträgt 200 Ω.

Weiter ist gemäß Figur 2 vorgesehen, dass das gemeinsame Anpassnetzwerk 25 insgesamt 4 Kondensatoren C₁, C₂, C₃ und C₄ aufweist, mit denen eine Anpassung der Impedanz von 200 Ω zwischen den Speisepunkten 33,34 an die Impedanz des Plasmas in dem ersten Plasmaerzeugungsbereich 18 beziehungsweise in dem zweiten Plasmaerzeugungsbereich 17 gewährleistet werden kann. Aufgrund der hohen, in den zweiten Plasmaerzeugungsbereich 17 eingekoppelten Hochfrequenzleistung ist diese Impedanzanpassung insbesondere für den zweiten Plasmaerzeugungsbereich 17 wichtig.

Weiter wird dann gemäß Figur 2 die eingekoppelte Hochfrequenzleistung an einem ersten Spulenende 36 und einem zweiten Spulenende 37 in die zweite ICP-Spule 15 eingekoppelt, die bevorzugt mit einem Mittelabgriff 32 versehen und darüber geerdet ist. Daneben ist vorgesehen, dass die zweite ICP-Spule 15 einen ersten Abgriff 30 und einen zweiten Abgriff 31 aufweist, die symmetrisch bezüglich des Mittelabgriffes 32 angeordnet sind. Über diesen ersten Abgriff 30 beziehungsweise den zweiten Abgriff 31 steht die zweite ICP-Spule 15 mit der ersten ICP-Spule 14 in Verbindung, die somit parallel zu dem zwischen den beiden Abgriffen 30, 31 befindlichen Teil der zweiten ICP-Spule 15 geschaltet ist.

Hinsichtlich weiterer Details zu der Funktion und der Ausgestaltung der einzelnen Komponenten des gemeinsamen Anpassnetzwerkes 25 sei auf DE 199 00 179 C1 verwiesen, wo diese Schaltung ausführlich beschrieben ist.

Insbesondere sei betont, dass gemäß Figur 2 die erste ICP-Spule 14 im Nebenschluss zu einem Teil der zweiten ICP-Spule 15 betrieben wird, wobei gleichzeitig eine symmetrische und balancierte Speisung für beide Spulen 14, 15 gewährleistet ist, die zudem einfach zu regeln ist.

## Patentansprüche

1. Plasmaätzanlage zum insbesondere anisotropen Ätzen eines Substrates (11) durch Einwirken eines Plasmas, mit einer ersten Plasmaerzeugungsvorrichtung (21), aufweisend:
ein erstes Mittel (14) zum Generieren eines ersten hochfrequenten elektromagnetischen Wechselfeldes,
einen ersten Plasmaerzeugungsbereich (18) zur Erzeugung eines ersten Plasmas aus reaktiven Teilchen durch Einwirken des ersten hochfrequenten elektromagnetischen Wechselfeldes auf ein erstes Reaktivgas, und
eine erste Gaszuführung (19), wobei das zu ätzende Substrat (11) in der ersten Plasmaerzeugungsvorrichtung (21) anordenbar ist,
wobei der ersten Plasmaerzeugungsvorrichtung (21) eine zweite Plasmaerzeugungsvorrichtung (20) vorgeschaltet ist, aufweisend:
ein zweites Mittel (15) zum Generieren eines zweiten hochfrequenten elektromagnetischen Wechselfeldes,
einen zweiten Plasmaerzeugungsbereich (17) zum Erzeugen eines zweiten Plasmas aus reaktiven Teilchen durch Einwirken des zweiten hochfrequenten elektromagnetischen Wechselfeldes auf ein zweites Reaktivgas, und
eine zweite Gaszuführung (16), wobei das zweite Plasma der ersten Plasmaerzeugungsvorrichtung (21) über die erste Gaszuführung (19) zumindest teilweise als erstes Reaktivgas zuführbar ist,
wobei die erste Plasmaerzeugungsvorrichtung (21) eine induktiv gekoppelte Plasmaerzeugungsvorrichtung (21) ist, die eine erste ICP-Spule (14) aufweist, und
wobei die zweite Plasmaerzeugungsvorrichtung (20) eine induktiv gekoppelte Plasmaerzeugungsvorrichtung (20) ist, die eine zweite ICP-Spule (15) aufweist,
**dadurch gekennzeichnet, dass**
die erste Plasmaerzeugungsvorrichtung (21) und die zweite Plasmaerzeugungsvorrichtung (20) ein gemeinsames Hochfrequenzbauteil mit einem gemeinsamen Hochfrequenzgenerator und einem gemeinsamen Anpassnetzwerk (25) aufweisen, wobei das Hochfrequenzbauteil mit der ersten ICP-Spule (14) und der zweiten ICP-Spule (15) in Verbindung steht, und
wobei die erste ICP-Spule (14) über einen ersten Abgriff (30) an der zweiten ICP-Spule (15) und. einen zweiten Abgriff (31) an der zweiten ICP-Spule (15) elektrisch einem Teil der zweiten ICP-Spule (15) parallel geschaltet ist.

2. Plasmaätzanlage nach Anspruch 1, **dadurch gekennzeichnet, dass** die erste Plasmaerzeugungsvorrichtung (21) eine über eine Zuleitung (12) mit einer Hochfrequenz-Spannungsquelle verbundene Substratelektrode (10) aufweist, mit der in dem ersten Plasma enthaltene Ionen auf das Substrat (11) hin beschleunigbar sind.

3. Plasmaätzanlage nach mindestens einem der vorangehenden Ansprüche, **dadurch gekennzeichnet, dass** die erste Plasmaerzeugungsvorrichtung (21) und die zweite Plasmaerzeugungsvorrichtung (20) über eine gasdurchlässsige, insbesondere geerdete Entladevorrichtung (19) miteinander verbunden sind, die eine zumindest teilweise Entladung von Ionen und/oder Elektroden aus dem zweiten Plasma bewirkt, und die insbesondere gleichzeitig als erste Gaszufuhr (19) dient.

4. Plasmaätzanlage nach Anspruch 3, **dadurch gekennzeichnet, dass** die Entladevorrichtung (19) eine metallische oder keramische Lochplatte, ein metallisches oder keramisches Netz, ein Duschkopf oder ein Gaszuführungsring ist.

5. Plasmaätzanlage nach mindestens einem der vorangehenden Ansprüche, **dadurch gekennzeichnet, dass** die erste und die zweite Plasmaerzeugungsvorrichtung (20,21) in einer gemeinsamen Reaktorkammer (13) derart hintereinander angeordnet und durch die gasdurchlässige Entladevorrichtung (19) derart voneinander getrennt sind, dass das der ersten Plasmaerzeugungsvorrichtung (21) zugeführte erste Reaktivgas zumindest nahezu vollständig durch die Entladevorrichtung (19) durchtritt.

6. Plasmaätzanlage nach mindestens einem der vorangehenden Ansprüche, **dadurch gekennzeichnet, dass** die gasdurchlässige Entladevorrichtung (19) derart in der Reaktorkammer (13) angeordnet ist, dass sie die Gasdurchtrittsfläche für ein Gas aus der zweiten Plasmaerzeugungsvorrichtung (20) in die erste Plasmaerzeugungsvorrichtung (21) auf 0,01% bis 80% der ohne die Entladevorrichtung (13) in der Reaktorkammer (13) vorliegenden Durchtrittsfläche zwischen den Plasmaerzeugungsvorrichtungen (20,21) reduziert.

7. Plasmaätzanlage nach mindestens einem der vorangehenden Ansprüche, **dadurch gekennzeichnet, dass** die Entladevorrichtung (19') beheizbar ist.

8. Plasmaätzanlage nach mindestens einem der vorangehenden Ansprüche, **dadurch gekennzeichnet, dass** das erste Hochfrequenzbauteil ein erster Hochfrequenzgenerator mit einem ersten Anpassnetzwerk zur Impedanzanpassung der ersten Plasmaerzeugungsvorrichtung (21) an die Impedanz des ersten Plasmas ist.

9. Plasmaätzanlage nach mindestens einem der vorangehenden Ansprüche, **dadurch gekennzeichnet, dass** mit dem ersten Hochfrequenzbauteil eine Leistung von 50 Watt bis 2000 Watt, insbesondere 400 Watt bis 1000 Watt, in das erste Plasma einkoppelbar ist.

10. Plasmaätzanlage nach mindestens einem der vorangehenden Ansprüche, **dadurch gekennzeichnet, dass** das zweite Hochfrequenzbauteil ein zweiter Hochfrequenzgenerator mit einem zweiten Anpassnetzwerk zur Impedanzanpassung der zweiten Plasmaerzeugungsvorrichtung (20) an die Impedanz des zweiten Plasmas ist.

11. Plasmaätzanlage nach mindestens einem der vorangehenden Ansprüche, **dadurch gekennzeichnet, dass** mit dem zweiten Hochfrequenzbauteil eine Leistung von 3000 Watt bis 7000 Watt in das zweite Plasma einkoppelbar ist.

12. Plasmaätzanlage nach mindestens einem der vorangehenden Ansprüche, **dadurch gekennzeichnet, dass** das erste und das zweite Hochfrequenzbauteil phasensynchronisiert bei einer gleichen Frequenz, insbesondere 13,56 MHz, betrieben werden, oder dass das erste Hochfrequenzbauteil und das zweite Hochfrequenzbauteil bei deutlich verschiedenen Frequenzen, insbesondere 12,56 MHz, 2 MHz oder 380 kHz für das erste Hochfrequenzbauteil und 13,56 MHz für das zweite Hochfrequenzbauteil, betrieben werden.

13. Plasmaätzanlage nach mindestens einem der vorangehenden Ansprüche, **dadurch gekennzeichnet, dass** über die Lage der Abgriffe (30,31) an der zweiten ICP-Spule (15) eine Einstellung des durch die erste ICP-Spule (14) und des durch den parallel geschalteten Teil der zweiten ICP-Spule (15) fließenden elektrischen Stromes und darüber der jeweils in das erste Plasma und das zweite Plasma eingekoppelten Leistung vornehmbar ist.

14. Plasmaätzanlage nach mindestens einem der vorangehenden Ansprüche, **dadurch gekennzeichnet, dass** das gemeinsame Anpassnetzwerk (25) ein symmetrisch aufgebautes Anpassnetzwerk (25) mit einer symmetrisch aufgebauten Spulenspeisung ist, und dass die zweite ICP-Spule (15) einen geerdeten Mittelabgriff (32) mit diesbezüglich symmetrisch angeordnetem ersten und zweiten Abgriff (30,31) aufweist.

15. Plasmaätzanlage nach mindestens einem der vorangehenden Ansprüche, **dadurch gekennzeichnet, dass** die Plasmaätzanlage so eingerichtet ist, dass der Druck in der zweiten Plasmaerzeugungsvorrichtung (20) höher einstellbar ist als in der ersten Plasmaerzeugungsvorrichtung (21), wobei die Druckdifferenz insbesondere 10 µbar bis 250 µbar beträgt.

16. Plasmaätzanlage nach mindestens einem der vorangehenden Ansprüche, **dadurch gekennzeichnet, dass** die Plasmaätzanlage so eingerichtet ist, dass der Druck in der zweiten Plasmaerzeugungsvorrichtung zwischen 30 µbar und 250 µbar einstellbar und der Druck in der ersten Plasmaerzeugungsvorrichtung (21) zwischen 5 µbar und 30 µbar einstellbar ist.

17. Plasmaätzanlage nach mindestens einem der vorangehenden Ansprüche, **dadurch gekennzeichnet, dass** über die erste Gaszuführung (19) und/oder die Entladevorrichtung (19) sowie die zweite Gaszuführung (16) die Druckdifferenz zwischen der ersten Plasmaerzeugungsvorrichtung (21) und der zweiten Plasmaerzeugungsvorrichtung (20) einstellbar ist.

## Claims

1. Plasma etching equipment for etching, especially anisotropic etching, of a substrate (11) through the action of a plasma, comprising a first plasma generating device (21), having:
a first means (14) for generating a high-frequency electromagnetic alternating field,
a first plasma generating area (18) for generating a first plasma from reactive particles by exposing a first reactive gas to the action of the first high-frequency electromagnetic alternating field, and
a first gas supply (19), wherein the substrate (11) to be etched can be arranged in the first plasma generating device (21),
wherein the first plasma generating device (21) is preceded by a second plasma generating device (20), having:
a second means (15) for generating a second high-frequency electromagnetic alternating field,
a second plasma generating area (17) for generating a second plasma from reactive particles by exposing a second reactive gas to the action of the second high-frequency electromagnetic alternating field, and
a second gas supply (16), wherein the second plasma can be supplied at least partly to the first plasma generating device (21) by way of the first gas supply (19) as the first reactive gas,
wherein the first plasma generating device (21) is an inductively coupled plasma generating device (21), which has a first ICP coil (14), and
wherein the second plasma generating device (20) is an inductively coupled plasma generating device (20), which has a second ICP coil (15),
**characterized in that**
the first plasma generating device (21) and the second plasma generating device (20) have a common high-frequency component with a common high-frequency generator and a common matching network (25), wherein the high-frequency component is connected to the first ICP coil (14) and the second ICP coil (15), and
wherein the first ICP coil (14) is electrically connected in parallel with part of the second ICP coil (15) by way of a first tap (30) on the second ICP coil (15) and a second tap (31) on the second ICP coil (15).

2. Plasma etching equipment according to Claim 1, **characterized in that** the first plasma generating device (21) has a substrate electrode (10), which is connected to a high-frequency voltage source by way of a supply line (12) and with which ions contained in the first plasma can be accelerated towards the substrate (11).

3. Plasma etching equipment according to at least one of the preceding claims, **characterized in that** the first plasma generating device (21) and the second plasma generating device (20) are connected to one another by way of a gas-permeable, in particular earthed, discharge device (19), which brings about an at least partial discharge of ions and/or electrodes from the second plasma, and which serves in particular at the same time as a first gas supply (19).

4. Plasma etching equipment according to Claim 3, **characterized in that** the discharge device (19) is a metallic or ceramic perforated plate, a metallic or ceramic mesh, a shower head or a gas supply ring.

5. Plasma etching equipment according to at least one of the preceding claims, **characterized in that** the first and second plasma generating devices (20, 21) are arranged one behind the other in a common reactor chamber (13) and are separated from one another by the gas-permeable discharge device (19) in such a way that the first reactive gas, supplied to the first plasma generating device (21), passes at least almost completely through the discharge device (19).

6. Plasma etching equipment according to at least one of the preceding claims, **characterized in that** the gas-permeable discharge device (19) is arranged in the reactor chamber (13) in such a way that it reduces the area for a gas to pass through from the second plasma generating device (20) into the first plasma generating device (21) to 0.01% to 80% of the area between the plasma generating devices (20, 21) through which gas passes without the discharge device (19) in the reaction chamber (13).

7. Plasma etching equipment according to at least one of the preceding claims, **characterized in that** the discharge device (19') is heatable.

8. Plasma etching equipment according to at least one of the preceding claims, **characterized in that** the first high-frequency component is a first high-frequency generator with a first matching network for matching the impedance of the first plasma generating device (21) to the impedance of the first plasma.

9. Plasma etching equipment according to at least one of the preceding claims, **characterized in that**, with the first high-frequency component, a power of 50 W to 2000 W, in particular 400 W to 1000 W, can be coupled into the first plasma.

10. Plasma etching equipment according to at least one of the preceding claims, **characterized in that** the second high-frequency component is a second high-frequency generator with a second matching network for matching the impedance of the second plasma generating device (20) to the impedance of the second plasma.

11. Plasma etching equipment according to at least one of the preceding claims, **characterized in that**, with the second high-frequency component, a power of 3000 W to 7000 W can be coupled into the second plasma.

12. Plasma etching equipment according to at least one of the preceding claims, **characterized in that** the first and second high-frequency components are operated in a phase-synchronized manner at an identical frequency, in particular 13.56 MHz, or **in that** the first high-frequency component and the second high-frequency component are operated at very different frequencies, in particular 12.56 MHz, 2 MHz or 380 kHz for the first high-frequency component and 13.56 MHz for the second high-frequency component.

13. Plasma etching equipment according to at least one of the preceding claims, **characterized in that** a setting of the electric current flowing through the first ICP coil (14) and of the electric current flowing through the parallel-connected part of the second ICP coil (15) can be performed by the position of the taps (30, 31) on the second ICP coil (15) and, by that setting, a setting of the power coupled into the first plasma and the second plasma can be performed.

14. Plasma etching equipment according to at least one of the preceding claims, **characterized in that** the common matching network (25) is a symmetrically constructed matching network (25) with a symmetrically constructed coil feed, and **in that** the second ICP coil (15) has an earthed centre tap (32) with first and second taps (30, 31) arranged symmetrically with respect to it.

15. Plasma etching equipment according to at least one of the preceding claims, **characterized in that** the plasma etching equipment is set up in such a way that the pressure in the second plasma generating device (20) can be set higher than in the first plasma generating device (21), the pressure difference being in particular 10 µbar to 250 µbar.

16. Plasma etching equipment according to at least one of the preceding claims, **characterized in that** the plasma etching equipment is set up in such a way that the pressure in the second plasma generating device can be set between 30 µbar and 250 µbar and the pressure in the first plasma generating device (21) can be set between 5 µbar and 30 µbar.

17. Plasma etching equipment according to at least one of the preceding claims, **characterized in that** the pressure difference between the first plasma generating device (21) and the second plasma generating device (20) can be set by way of the first gas supply (19) and/or the discharge device (19) as well as the second gas supply (16).

## Revendications

1. Installation de gravure au plasma, en particulier pour graver de manière anisotrope un substrat (11) par action d'un plasma, dotée d'un premier dispositif (21) de production d'un plasma qui présente :
un premier moyen (14) qui produit un premier champ électromagnétique alternatif à haute fréquence,
une première zone (18) de production de plasma qui produit un premier plasma à partir de particules réactives par action du premier champ électromagnétique alternatif à haute fréquence sur un gaz réactif et
une première amenée de gaz (19), le substrat (11) à graver pouvant être disposé dans le premier dispositif (21) de production d'un plasma,
le premier dispositif (21) de production d'un plasma étant précédé par un deuxième dispositif (20) de production d'un plasma qui présente :
un deuxième moyen (15) qui produit un deuxième champ électromagnétique alternatif à haute fréquence,
une deuxième zone (17) de production d'un plasma qui produit un deuxième plasma à partir de particules réactives par action du deuxième champ électromagnétique à haute fréquence sur un deuxième gaz réactif et
une deuxième amenée de gaz (16), le deuxième plasma du premier dispositif (21) de production de plasma pouvant être amené par la première amenée de gaz (19) au moins en partie comme premier gaz réactif,
le premier dispositif (21) de production de plasma étant un dispositif (21) de production de plasma par couplage inductif qui présente une première bobine ICP (14) et
le deuxième dispositif (20) de production de plasma étant un dispositif (20) de production de plasma à couplage inductif qui présente une deuxième bobine ICP (15),
**caractérisée en ce que**
le premier dispositif (21) de production de plasma et le deuxième dispositif (20) de production de plasma présentent un composant commun à haute fréquence doté d'un générateur commun de haute fréquence et d'un réseau commun d'adaptation (25), le composant à haute fréquence étant relié à la première bobine ICP (14) et à la deuxième bobine ICP (15) et
**en ce que** la première bobine ICP (14) est raccordée électriquement en parallèle à une partie de la deuxième bobine ICP (15) par une première borne de prélèvement (30) prévue sur la deuxième bobine ICP (15) et par une deuxième borne de prélèvement (31) prévue sur la deuxième bobine ICP (15).

2. Installation de gravure au plasma selon la revendication 1, **caractérisée en ce que** le premier dispositif (21) de production de plasma présente une électrode de substrat (10) reliée à une source de tension à haute fréquence par un conducteur d'amenée (12) et par laquelle les ions que contient le premier plasma peuvent être accélérés en direction du substrat (11).

3. Installation de gravure au plasma selon au moins l'une des revendications précédentes, **caractérisée en ce que** le premier dispositif (21) de production de plasma et le deuxième dispositif (20) de production de plasma sont reliés l'un à l'autre par un dispositif (19) de décharge perméable aux gaz et en particulier raccordé à la masse, qui a pour effet une décharge au moins partielle d'ions et/ou d'électrodes du deuxième plasma, en particulier en même temps que la première amenée de gaz (19).

4. Installation de gravure au plasma selon la revendication 3, **caractérisée en ce que** le dispositif de décharge (19) est une plaque perforée en métal ou en céramique, un treillis métallique ou en céramique, un pommeau de douche ou un anneau d'amenée de gaz.

5. Installation de gravure au plasma selon au moins l'une des revendications précédentes, **caractérisée en ce que** le premier et le deuxième dispositif (20, 21) de production de plasma sont disposés l'un derrière l'autre dans une chambre commune (13) de réacteur et peuvent être séparés l'un de l'autre par le dispositif (19) de décharge perméable aux gaz de telle sorte que le premier gaz réactif apporté au premier dispositif (21) de production de plasma traverse au moins presque complètement le dispositif de décharge (19).

6. Installation de gravure au plasma selon au moins l'une des revendications précédentes, **caractérisée en ce que** le dispositif (19) de décharge perméable aux gaz est disposé de telle sorte qu'il réduit la surface de passage de gaz prévue dans la chambre (13) du réacteur pour un gaz se déplaçant du deuxième dispositif (20) de production de plasma au premier dispositif (21) de production de plasma à entre 0,01 et 80 % de la surface de passage présente dans la chambre (13) du réacteur entre les dispositifs (20, 21) de production de plasma sans le dispositif de décharge (19).

7. Installation de gravure au plasma selon au moins l'une des revendications précédentes, **caractérisée en ce que** le dispositif de décharge (19') peut être chauffé.

8. Installation de gravure au plasma selon au moins l'une des revendications précédentes, **caractérisée en ce que** le premier composant à haute fréquence est un premier générateur de haute fréquence doté d'un premier réseau d'adaptation qui adapte l'impédance du premier dispositif (21) de production de plasma à l'impédance du premier plasma.

9. Installation de gravure au plasma selon au moins l'une des revendications précédentes, **caractérisée en ce qu'**une puissance de 50 watts à 2 000 watts et en particulier de 400 watts à 1 000 watts peut être injectée dans le premier plasma par le premier composant à haute fréquence.

10. Installation de gravure au plasma selon au moins l'une des revendications précédentes, **caractérisée en ce que** le deuxième composant à haute fréquence est un deuxième générateur de haute fréquence doté d'un deuxième réseau d'adaptation qui adapte l'impédance du deuxième dispositif (20) de production de plasma à l'impédance du deuxième plasma.

11. Installation de gravure au plasma selon au moins l'une des revendications précédentes, **caractérisée en ce qu'**une puissance de 3 000 watts à 7 000 watts peut être injectée dans le deuxième plasma par le deuxième composant à haute fréquence.

12. Installation de gravure au plasma selon au moins l'une des revendications précédentes, **caractérisée en ce que** le premier et le deuxième composant à haute fréquence sont utilisés en synchronisation de phase à une même fréquence, en particulier de 13,56 MHz, ou **en ce que** le premier composant à haute fréquence et le deuxième composant à haute fréquence sont utilisés à des fréquences nettement différentes, en particulier de 12,56 MHz, 2 MHz ou 380 kHz pour le premier composant à haute fréquence et de 13,56 MHz pour le deuxième composant à haute fréquence.

13. Installation de gravure au plasma selon au moins l'une des revendications précédentes, **caractérisée en ce que** par la position des bornes de prélèvement (30, 31) sur la deuxième bobine ICP (15), on peut entreprendre un réglage du courant électrique qui traverse la première bobine ICP (14) et la partie, branchée en parallèle, de la deuxième bobine ICP (15), pour ainsi régler la puissance injectée dans le premier plasma et le deuxième plasma.

14. Installation de gravure au plasma selon au moins l'une des revendications précédentes, **caractérisée en ce que** le réseau commun d'adaptation (25) est un réseau d'adaptation (25) à structure symétrique doté d'une alimentation de bobine à structure symétrique et **en ce que** la deuxième bobine ICP (15) présente une borne centrale de prélèvement (32) raccordée à la masse, la première et la deuxième borne de prélèvement (30, 31) étant disposées symétriquement par rapport à la borne centrale.

15. Installation de gravure au plasma selon au moins l'une des revendications précédentes, **caractérisée en ce que** l'installation de gravure au plasma est conçue de telle sorte que la pression qui règne dans le deuxième dispositif (20) de production de plasma peut être réglée à une valeur plus élevée que dans le premier dispositif (21) de production de plasma, la différence de pression étant en particulier comprise entre 10 µbars et 250 µbars.

16. Installation de gravure au plasma selon au moins l'une des revendications précédentes, **caractérisée en ce que** l'installation de gravure au plasma est conçue de telle sorte que la pression qui règne dans le deuxième dispositif de production de plasma peut être réglée entre 30 µbars et 250 µbars et **en ce que** la pression qui règne dans le premier dispositif (21) de production de plasma peut être réglée entre 5 µbars et 30 µbars.

17. Installation de gravure au plasma selon au moins l'une des revendications précédentes, **caractérisée en ce que** la différence de pression entre le premier dispositif (21) de production de plasma et le deuxième dispositif (20) de production de plasma peut être réglée par l'intermédiaire de la première amenée de gaz (19) et/ou du dispositif de décharge (19) ainsi que par la deuxième amenée de gaz (16).
